# EUROPEAN PATENT APPLICATION

(11) **EP 4 811 655 A1**
(43) Date of publication of application: **23.09.2026**
(21) Application number: 25165104.8
(22) Date of filing: 20.03.2025
(51) Int. Cl.: H03F 1/32, H03F 3/185, H03F 3/45, H03F 3/50

(54) **AMPLIFIER CIRCUIT BUILDING BLOCK**

(71) Applicant: Harman International Industries, Incorporated, Stamford, CT 06901 (US)
(72) Inventor: KOVÁCS, Ákos, 1091 Budapest (HU)
(74) Representative: Rummler, Felix

(57) **Abstract**

There is provided an electrical circuit that can serve as a building block for an impedance converter amplifier, particularly advantageous for use in a condenser microphone. The circuit topology comprises: a pair of transistors comprising a first transistor and a second transistor, wherein a first terminal of the first transistor is configured to connect to a first terminal of a third transistor and a first terminal of the second transistor is configured to connect to a first terminal of the fourth transistor, wherein the third and fourth transistors form a differential input pair, wherein a second terminal of the first transistor is connected to a second terminal of the second transistor; a first current source for providing a constant current stream, wherein the first current source is connected to the second terminal of the first transistor and the second terminal of the second transistor; a voltage follower, wherein an output terminal of the voltage follower is connected to the constant current stream, wherein a second terminal of the voltage follower is connected to a second terminal of the third transistor and a second terminal of the fourth transistor; and a voltage source for providing a voltage drop in the constant current stream, wherein the voltage source is connected between the output terminal of the voltage follower and the second terminals of the first and second transistors.

## Description

The present disclosure provides a circuit building block for use in an impedance converter amplifier for a condenser microphone.

### BACKGROUND OF THE INVENTION

In condenser microphones, sound pressure is converted into electrical signals, typically by way of an electrically charged membrane placed close to a backplate in a capsule, the pair forming a capacitor. As the membrane vibrates in reaction to sound waves, the distance between it and backplate changes and alters the capacitance that can be converted into an electrical signal.

When change in air pressure happens, the voltage difference between the two electrodes in the capsule changes. In most current microphone capsules, the voltage of the signal is sufficiently large, but the current is extremely low. Impedance converter amplifiers are used, which help to avoid loading down the capacitive capsule. The impedance converter presents a very high input impedance and a much lower output impedance, so that a traditional microphone preamplifier can handle the signal level matching during operation.

It is necessary to mitigate sources of distortion. One such source is the inherent, parasitic capacitances associated with input transistors; this is especially true with the differential input pair of transistors in setups where a differential amplifier/operational amplifier (opamp) is used (although single-ended amplifier circuits are also used and face the same problem described here).

In normal operation, the input transistors (e.g. differential input JFET transistors at the positive and negative inputs respectively) input capacitances need to be dynamically charged and discharged by the source that drives the gate. When the output impedance of the source is high - such as in the case of a condenser microphone capsule where the output impedance is in the range of 100kΩ to 1MΩ - the dynamic charge-and-discharge action cannot be supplied by the source, which ultimately causes non-linear distortion to appear on the output.

These parasitic capacitances attenuate the signal at the beginning of the input stage, and prevent the full signal to be passed on; further, the level of distortion increases as the amount of parasitic capacitance increases. Since the distortion comes from the input-capsule interaction, constructing a negative feedback loop around the transistor will not reduce distortion. Note that in the case of a monolithic opamp, the non-linear behaviour of the substrate to gate capacitance further exacerbates the distortion.

There is thus a need to anticipate and alleviate distortion in impedance converter amplifiers. Often, the impedance converter has to be designed with the right components and circuit topology involving a bootstrapping element. Combined with the common issue of parameter spread, electrical components often have to be hand-selected for proper bootstrap operation, otherwise the circuit may suffer from severe non-linearity, due to the input transistors entering the low VDS "triode" region, or worse, may not work altogether. This causes challenges in mass production of bootstrapped impedance converters for microphones.

### SUMMARY

In accordance with at least one embodiment of the present disclosure, there is provided an electrical circuit or building block thereof, for an impedance converter amplifier or operational amplifier, particularly advantageous for use in a condenser microphone in that it provides a non-linear capacitance cancellation scheme. The electrical circuit comprises: a pair of transistors comprising a first transistor and a second transistor, wherein a first terminal of the first transistor is configured to connect to a first terminal of a third transistor and a first terminal of the second transistor is configured to connect to a first terminal of the fourth transistor, wherein the third and fourth transistors form a differential input pair, wherein a second terminal of the first transistor is connected to a second terminal of the second transistor; a first current source for providing a constant current stream, wherein the first current source is connected to the second terminal of the first transistor and the second terminal of the second transistor; a voltage follower, wherein an output terminal of the voltage follower is connected to the constant current stream, wherein a second terminal of the voltage follower is connected to a second terminal of the third transistor and a second terminal of the fourth transistor; and a voltage source for providing a voltage drop in the constant current stream, wherein the voltage source is connected between the output terminal of the voltage follower and the second terminals of the first and second transistors.

The electrical circuit may be part of a differential input stage of the impedance converter amplifier/operational amplifier, wherein respective third terminals of the third and fourth transistors are configured as input terminals to receive the (differential) input signal.

Optionally, each of the third and fourth transistors may comprise a field effect transistor (FET); they may be JFETs or MOSFETs. Optionally, the first terminals of the third and fourth transistors are drain terminals. Optionally, the third terminals of the third and fourth transistors are gate terminals. Optionally, the second terminals of the third and fourth transistors are source terminals,

Each of the first and second transistors may comprise a bipolar junction transistors (BJT) or FET. If they are BJTs, optionally, the second terminals of the first and second transistors are their base terminals, and/or the first terminals of the first and second transistors are their emitter terminals. If they are FETs, optionally, the second terminals of the first and second transistors are their gate terminals, wherein the first and second transistors are FETs, and the first terminals of the first and second transistors are their source terminals.

The voltage follower may comprise a BJT, in which case the second terminal of the voltage follower may be a gate terminal and the output terminal may be an emitter terminal. The voltage follower may comprise a FET, in which case the second terminal of the voltage follower may be a base terminal and the output terminal may be a source terminal.

The electrical circuit may further comprise a second current source, connected to the second terminals of the third and fourth transistors and the second terminal of the voltage follower.

The first transistor, the second transistor, the first current source, the voltage source and the voltage follower may effectively form a bootstrap circuit, or a part thereof, configured to hold the third terminals of the third and fourth transistors relative to each other.

Optionally, the first transistor and the third transistor form a first cascode pair, whilst the second transistor and the fourth transistor form a second cascode pair.

Optionally, the first and second transistors are NPN-type BJTs, the third and fourth transistors are N-channel JFETs, and the voltage follower comprises a PNP-type BJT; alternatively, the first and second transistors are PNP-type BJTs, the third and fourth transistors are P-channel JFETs, and the voltage follower comprises an NPN-type BJT.

Optionally, the voltage source comprises a programmable voltage reference.

Optionally, the electrical circuit further comprises a current mirror section, which preferably comprises fifth and sixth transistors coupled to the first and second transistors, the former pair being of a corresponding type to the latter pair.

It is also herein disclosed an impedance converter amplifier or operational amplifier that comprises the above electric circuit, preferably as a differential input stage or a part thereof.

It is further disclosed an apparatus, such as a microphone (in particular a high-impedance condenser microphone comprising a microphone capsule), comprising the above impedance converter amplifier/operational amplifier or electrical circuit.

In order that the present invention be more readily understood, various aspects of specific embodiments will now be described in conjunction with the attached drawings.

### BRIEF DESCRIPTION OF THE DRAWINGS

Fig. 1 shows a circuit building block for use in an impedance converter amplifier for a condenser microphone, in accordance with one or more embodiments;
Fig. 2 shows a circuit building block for use in an impedance converter amplifier for a condenser microphone, in accordance with one or more embodiments;
Fig. 3 shows a circuit topology for an operational amplifier for a condenser microphone, in accordance with one or more embodiments.

### DETAILLED DESCRIPTION OF THE PREFERRED EMBODIMENTS

The present disclosure provides a circuit topology 100, 200, 300 for building an operational amplifier (opamp), more specifically for the differential input stage 300A for an impedance converter amplifier, which may also include a voltage amplification section and an output section, that is suitable for use in a high-impedance condenser microphone.

This comprises an arrangement of connected components that can be thought of as a circuit building block 100 for use in opamps or opamp-style circuit topologies. It provides a non-linear capacitance cancellation scheme for ultra-high impedance amplifiers. In other words, its use advantageously improves the linearity of an impedance converter amplifier in condenser microphones for example, as well as the linearity of the condenser microphone capsule itself.

The arrangement comprises a self-biased cascode (or cascode-like) configuration of transistors, with a differential pair of input transistors 110, 112 which are preferably FETS (JFETs or MOSFETs). This is a bootstrapping arrangement that holds the input terminals 110G, 112G relative to each other, so the source and the drain terminals have to follow the gate's dynamic motion. In other words, a controlled positive feedback is applied to the drain from the source. Note that it is possible to use, for the differential input pair 110, 112, bipolar junction transistors (BJTs) (in which case the emitter and collector terminals follow the base's dynamic motion) but this is not preferred for a condenser microphone impedance converter.

Advantageously, the bootstrapping action reduces the input capacitance of the input stage 300A of the differential amplifier circuit 300, leading to a reduction of distortion products inherently created by the microphone capsule itself. It nullifies or reduces the input signal-dependent, non-linear modulation of the input transistors' parasitic capacitances (cancelling the effect of intrinsic capacitances of both sides of an input FET), which is often the dominant source of distortion in condenser microphone impedance converters.

Further advantages to the circuit topology described below include:
1) It can be used as a building block to be incorporated into a traditional operational amplifier-style circuit topology.
2) Its performance is not affected by parameter spread, and there is a lower need for parameter matching; it is therefore a very stable topology.
3) The circuit consumes a low current (e.g. only around 200uA).
4) There is no need for hand-trimming (in some topologies, due to large DC offsets present on the output, emitter resistors requires trimming or more optimal bias conditions).
5) The VDS voltages of the input transistors can be adjusted.
6) Output offset voltage is inherently minimised by use of a differential input stage.

### Detailed description

It is herein disclosed a circuit building block 100, 200, 300 for use in an opamp or impedance converter amplifier for a condenser microphone. The main features of circuit topology can be described thus:
A voltage follower 130 is connected to the differential amplifier's tail. It outputs its voltage into a constant current stream provided by a current source 150. In the constant current stream, there are two cascode-like transistors 120, 122 that drive the differential pair input transistors 110, 112. A voltage reference 140 is placed into the constant current stream between the output of the follower 130 and bases of the cascode transistors 120, 122.

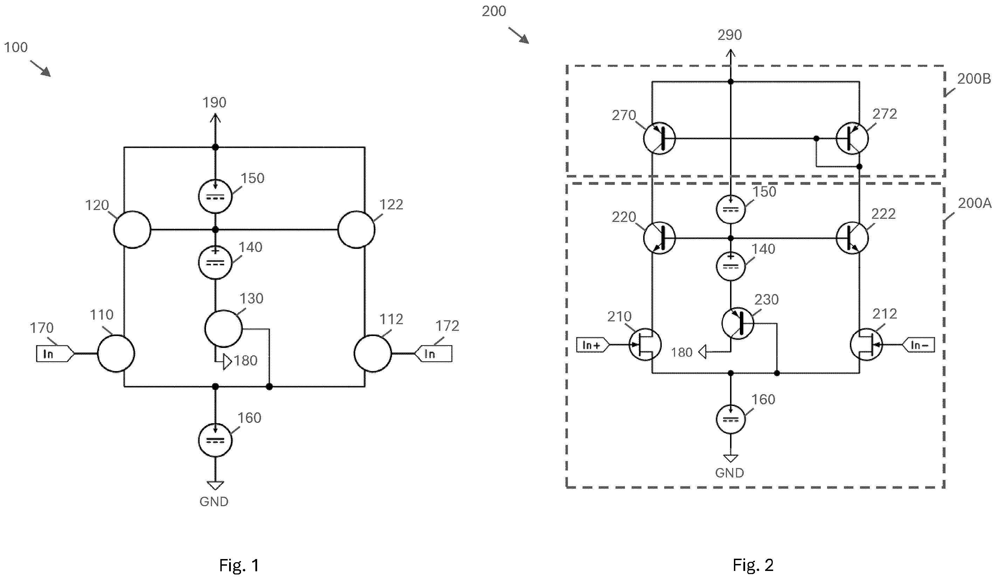

Fig. 1 illustrates an example 100 of such a circuit topology. It shows part of an opamp circuitry in accordance with a first embodiment. Fig. 2 provides more detail in accordance with the same embodiment or other embodiments.

There is provided a differential input, comprising a first input transistor 110 and a second input transistor 112 that are matched and source-coupled. In the preferred example, shown in Fig. 2, JFETs, specifically N-channel JFETs 210, 212, are used. The positive and negative input signals are provided at the respective gate terminals 170, 172 of these input JFETs. Alternatively, the input transistors 110, 112 may be P-channel JFETs, N-channel MOSFETs, or P-channel MOSFETs, but these may be less preferred options.

There are provided a pair of transistors 120, 122, preferably of the same type. In the preferred example shown in Fig. 2 they are both bipolar junction transistors (BJTs), specifically NPN-type BJTs 220, 222. It is also possible to use FETs (e.g. MOSFETs). They are connected to and configured to drive the differential pair input transistors 110/210, 112/212. The base terminals of this pair of transistors 120/220, 122/222 (gate terminals if FETs are used) are connected to each other. This results in a cascode or cascode-like arrangement in the circuit, and these two transistors can be called a pair of cascode-like transistors 120/220, 122/222. The cascode action is between an input transistor 110/210 or 112/212 (a common source amplifier, in this example a JFET) and a corresponding cascode-like transistor 120/220 or 122/222 (a common base amplifier, in this example a BJT) to which it is directly coupled. Due to its symmetrical nature, the circuit topology 100/200 can be said to comprise two "cascodes". Incorporating the cascode transistor pair 120/220, 122/222 in this manner enables implementation of a bootstrap circuit to hold the differential inputs 170, 172 of the impedance converter relative to each other. Note that if an N-channel FET is used as an input transistor, an NPN-type BJT or N-channel FET should be used as the corresponding cascode-like transistor, and vice versa.

In the illustrated example, the emitter terminal of each of the two cascode-like transistors 220, 222 is connected respectively to the drain terminal of each of the input JFETs 210, 212.

There is provided a first current source 150 (DC), in the bootstrap circuit, for providing a constant current stream. It is connected to a supply voltage 190/290.

There is provided a voltage source 140, also known as a voltage reference (DC).

The base terminals of the two cascode-like transistors 220, 222, aside from being connected to each other, are further connected to the first current source 250 and the voltage source 240.

There is provided a voltage follower component 130, connected to the tail of the differential amplifier (the two input transistors 110, 112 being traditionally called the long-tailed pair) where a second current source 160 is provided. This voltage follower is configured to provide isolation between bootstrap circuit and the differential amplifier tail, so that DC bias current is not injected from the former to the latter. The exact implementation of this voltage follower 130 need not be limited and can be done in different ways. In the example shown in Fig. 2, a PNP-type BJT transistor 230 is used as the voltage follower, as the input transistors 210, 212 are N-channel; a P-channel FET can also be used; (if the input transistors are P-channel, a NPN-type BJT or N-channel FET can be used as the voltage follower component). The base terminal (gate if a FET is used) is connected to the tail, that is to the source terminal of each of the differential pair input FETs 210, 212 and the second current source 160. The emitter terminal (source if a FET is used) is connected to the bootstrap circuit current source 150. The collector terminal (drain if a FET is used) is connected to ground, or an appropriate voltage supply rail.

The voltage follower 130/230 outputs voltage into the constant current stream provided by the current source 150.

The voltage source/reference 140 is placed in the constant current stream between the output (the emitter terminal as shown in Fig. 1) of the voltage follower 130/230 and the bases of the cascode transistors 120/220, 122/222. The voltage source 140 creates a voltage drop. This allows the two cascode-like transistors, which are also in the constant current stream, to properly bias the different pair JFET input transistors 110/210, 112/212. This helps to avoid operating in the non-linear, low-VDS triode region.

Additional to the above-described circuit topology 100 suitable for use as part of a differential input stage in an opamp, there is preferably connected thereto a current mirror circuit.

Fig. 2 shows the circuit topology 100 in Fig. 1 as a box 200A with additional components connected which form a current mirror loaded differential amplifier topology 200. The concept of a current mirror section 200B is already known and is here only briefly described.

There are provided a pair of transistors 270, 272 each connected to a respective one of the cascode-like transistors 120/220, 122/222 described above. In the example where the latter are a pair of NPN bipolar transistors, the two transistors 270, 272 in the current mirror are PNP bipolar transistors. The collector of each of the cascode-like transistors is coupled to the collector of a respective one of the current-mirror transistors 270, 272. The base terminals of the latter are connected to each other. For one of the current-mirror transistors, the base terminal and the collector terminal are coupled together; in the example of Fig. 2, this is the transistor 272 that is connected to the cascode-like transistor 222 that is itself connected to the negative input JFET 212. Each of the emitter terminals of the current-mirror transistors 270, 272 are connected to the supply voltage 290.

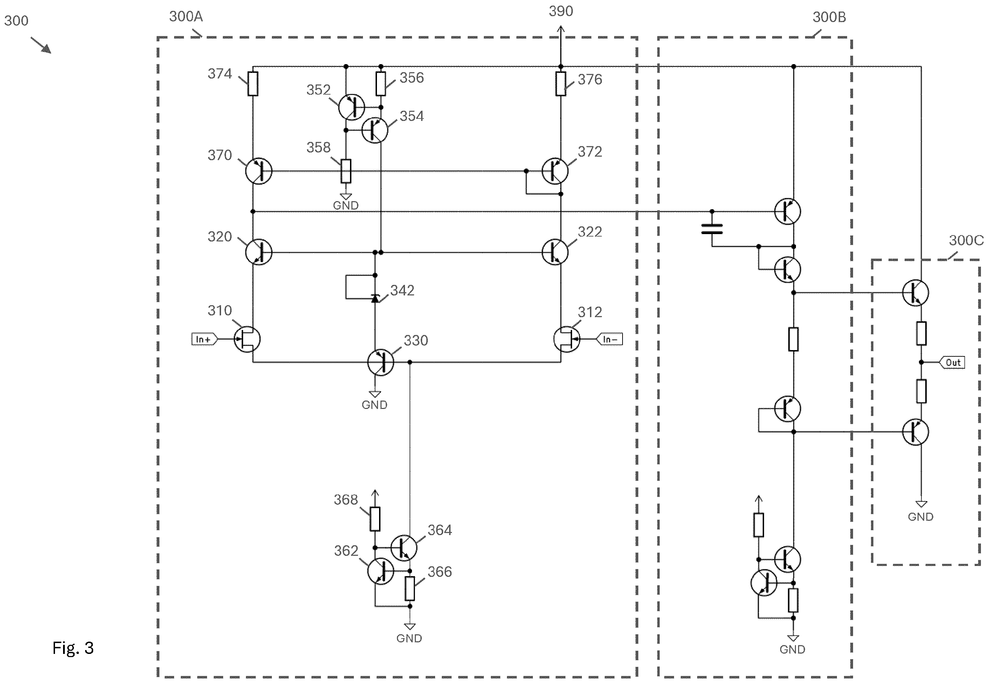

Fig. 3 illustrates an example of a prototype operational/differential amplifier circuit 300 for an impedance converter amplifier. It includes a differential input stage section 300A, a voltage amplification section 300B, and an output section 300C.

The differential input stage 300A includes an implementation of the building block 100, 200 shown in Figs. 1 and 2 and as above described.

The generalised voltage source 140 discussed above in relation to Figs. 1 and 2 can be implemented in different ways. Preferably, there is provided a programmable voltage reference that creates a specific voltage drop inside the constant current stream, programmed with a resistive divider for example. One non-limiting example is shown in Fig. 3, wherein the implementation involves a Zener diode (shunt regulator) 342, with the two terminals connected together (to create a 2.5 V voltage reference, for example), with the anode coupled to the voltage follower 330 (specifically the emitter terminal of the voltage follower which is a PNP transistor).

The generalised first current source 150 discussed above in relation to Fig. 1 can be implemented in different ways. One non-limiting example is shown in Fig. 3. In this example, the current source comprises two bipolar transistors 352, 354 and two fixed resistors 356, 358. Specifically: the transistors are both PNP-type BJTs ; the base of the first transistor 352 is connected to the emitter of the second transistor 354 and to the supply voltage 390 of the opamp circuit (e.g. +15V) via the first resistor 356; the base of the second transistor 354 is connected to the collector of the first transistor 352 and to ground/an appropriate voltage supply rail via the second resistor 358; the collector of the second transistor 354 is coupled to the pair of cascode-like transistors 320, 322 and the voltage reference 342, 344.

Similarly, the generalised second current source 160 discussed above in relation to Fig. 1 can be implemented in different ways. One non-limiting example is shown in Fig. 3. In this example, the current source comprises two bipolar transistors 362, 364 and two fixed resistors 366, 368. Specifically: the transistors are both NPN-type BJTs; the base of the first transistor 362 is connected to the emitter of the second transistor 364 and to a supply voltage (e.g. +15V) via the first resistor 366; the base of the second transistor 364 is connected to the collector of the first transistor 362 and to ground/an appropriate voltage supply rail via the second resistor 368; the collector of the second transistor 364 is coupled to the pair of input transistors 310, 312 and the voltage follower 330.

In the current mirror, each of the pair of transistors 370, 372 as above described are connected to the supply voltage via a respective resistor 374, 376.

The collector terminals of the current-mirror transistor 370 and of the cascode-like transistor 320 on the side where the latter is connected to the input JFET 310 for the positive input signal, are coupled to the voltage amplification section 300B of the opamp 300. The voltage amplification section 300B and output stage 300C are not described in detail here.

It is emphasised that Fig. 3 provides an example of how the circuit building block 100, 200 for an amplifier differential input stage can be used; the current source(s) and voltage source(s) can be realised in different ways based on the actual situation (e.g. dependent on whether it is a low- or high-current environment). Transistors shown in Figs. 1 and 2 may also be replaced by other types where appropriate, as well as other components and sections in Fig. 3.

The present invention is not to be limited by the above-described aspects and embodiments, and that many variations are within the scope of the appended claims. The various aspects and embodiments may be combined if necessary and appropriate. The drawings serve as exemplary illustrations of the invention only, to aid understanding of the invention.

## Claims

1. An electrical circuit for an impedance converter amplifier, comprising:
a pair of transistors comprising a first transistor and a second transistor, wherein a first terminal of the first transistor is configured to connect to a first terminal of a third transistor and a first terminal of the second transistor is configured to connect to a first terminal of the fourth transistor, wherein the third and fourth transistors form a differential input pair, wherein a second terminal of the first transistor is connected to a second terminal of the second transistor;
a first current source for providing a constant current stream, wherein the first current source is connected to the second terminal of the first transistor and the second terminal of the second transistor;
a voltage follower, wherein an output terminal of the voltage follower is connected to the constant current stream, wherein a second terminal of the voltage follower is connected to a second terminal of the third transistor and a second terminal of the fourth transistor; and
a voltage source for providing a voltage drop in the constant current stream, wherein the voltage source is connected between the output terminal of the voltage follower and the second terminals of the first and second transistors.

2. The electrical circuit according to claim 1, wherein the electrical circuit is part of a differential input stage of a differential amplifier, wherein respective third terminals of the third and fourth transistors are configured to receive an input signal.

3. The electrical circuit according to any one of claims 1 to 2, wherein the third and fourth transistors are field effect transistor (FETs).

4. The electrical circuit according to claim 3, wherein the first terminals of the third and fourth transistors are drain terminals, and/or wherein the third terminals of the third and fourth transistors are gate terminals.

5. The electrical circuit according to any one of claims 1 to 4,
wherein the first and second transistors are bipolar junction transistors (BJTs), and the second terminals of the first and second transistors are their base terminals, or
wherein the first and second transistors are FETs, and the second terminals of the first and second transistors are their gate terminals.

6. The electrical circuit according to any one of claims 1 to 5,
wherein the first and second transistors are BJTs, and the first terminals of the first and second transistors are their emitter terminals, or
wherein the first and second transistors are FETs, and the first terminals of the first and second transistors are their source terminals.

7. The electrical circuit according to any one of claims 1 to 6,
wherein the voltage follower comprises a BJT, and the second terminal of the voltage follower is a gate terminal and the output terminal is an emitter terminal, or
wherein the voltage follower comprises a FET, and the second terminal of the voltage follower is a base terminal and the output terminal is a source terminal.

8. The electrical circuit according to any one of claims 1 to 7, further comprising a second current source, connected to the second terminals of the third and fourth transistors and the second terminal of the voltage follower.

9. The electrical circuit according to any one of claims 1 to 8, wherein the first transistor, the second transistor, the first current source, the voltage source and the voltage follower form a bootstrap circuit or a part thereof for holding the third terminals of the third and fourth transistors relative to each other.

10. The electrical circuit according to any one of claims 1 to 9, wherein the first transistor and the third transistor form a first cascode pair, and the second transistor and the fourth transistor form a second cascode pair.

11. The electrical circuit according to any one of claims 1 to 10, wherein the first and second transistors are NPN-type BJTs, the third and fourth transistors are N-channel JFETs, and the voltage follower comprises a PNP-type BJT.

12. The electrical circuit according to any one of claims 1 to 10, wherein the first and second transistors are PNP-type BJTs, the third and fourth transistors are P-channel JFETs, and the voltage follower comprises an NPN-type BJT.

13. The electrical circuit according to any one of claims 1 to 12, wherein the voltage source comprises a programmable voltage reference.

14. An impedance converter amplifier or operational amplifier, comprising the electric circuit according any one of claims 1 to 13 as a differential input stage or a part thereof.

15. A condenser microphone comprising the impedance converter amplifier or operational amplifier according to claim 14.
